# EUROPÄISCHE PATENTSCHRIFT

(11) **EP 2 392 934 B1**
(45) Veröffentlichungstag und Bekanntmachung des Hinweises auf die Patenterteilung: **06.02.2019**
(21) Anmeldenummer: 10005744.7
(22) Anmeldetag: 02.06.2010
(51) Int. Cl.: G01R 31/12, H02H 3/04

(54) **Verfahren und Vorrichtung zur Überwachung eines Mantelspannungsableiters eines Kabelsystems**
Method and device for monitoring a sheath voltage arrester of a cable system
Procédé et dispositif de surveillance d'un parafoudre d'un système de câble

(43) Veröffentlichungstag der Anmeldung: 07.12.2011
(73) Patentinhaber: Omicron Energy Solutions GmbH, 12099 Berlin (DE)
(72) Erfinder: Emanuel, Harald, 10553 Berlin (DE); Plath, Ronald, 13503 Berlin (DE); Kessler, Ole, 13597 Berlin (DE)
(74) Vertreter: Banzer, Hans-Jörg

(56) Entgegenhaltungen:
- DE-A1- 19 629 481
- JP-A- 3 001 476
- PETRY W ET AL: "EINLEITERKABEL MIT AUSGEKREUZTEN MAENTELN", ELEKTRIZITAETSWIRTSCHAFT, VEREINIGUNG DEUTSCHER ELEKTRIZITAETZSWERKE, FRA, DE, Bd. 70, Nr. 26, 20. Dezember 1971 (1971-12-20), Seiten 753-761, XP002045842, ISSN: 0013-5496
- PARMIGIANI B; QUAGGIA D; ELLI E; FRANCHINA S: "ZINC OXIDE SHEATH VOLTAGE LIMITER FOR HV AND EHV POWER CABLE: FIELD EXPERIENCE AND LABORATORY TESTS", IEEE TRANSACTIONS ON POWER DELIVERY, Bd. PWRD-1, Nr. 1, Januar 1986 (1986-01), Seiten 164-170, XP002614598,
- FRUTH B A ET AL: "Combination of frequency spectrum analysis and partial discharge pattern recording", ELECTRICAL INSULATION, 1994., CONFERENCE RECORD OF THE 1994 IEEE INTER NATIONAL SYMPOSIUM ON PITTSBURGH, PA, USA 5-8 JUNE 1994, NEW YORK, NY, USA,IEEE, 5. Juni 1994 (1994-06-05), Seiten 296-300, XP010139506, DOI: DOI:10.1109/ELINSL.1994.401508 ISBN: 978-0-7803-1942-4
- P. Mohaupt; M. Gamlin; R. Gleyvod; J. Kraus; G. Voigt: "High Voltage Testing using Series Resonance with Variable Frequency", , Mai 2000 (2000-05), Seiten 1-6, XP002614599, Gefunden im Internet: URL:http://www.haefely.com/pdf/scientific/ e1-85.pdf [gefunden am 2010-12-15]
- OSZTERMAYER J; CARDILLO E; MARKALOUS S M; WIMMER R; LENZ M; HOEK S M; FESER K: "Asset management based on improved online monitoring systems applied to a 110/380 kV substation", 2003 IEEE BOLOGNA POWERTECH, 23. Juni 2003 (2003-06-23), - 26. Juni 2003 (2003-06-26), Seiten 1-5, XP002614600,

## Beschreibung

Die vorliegende Erfindung betrifft ein Verfahren sowie eine Vorrichtung zur Überwachung eines Mantelspannungsableiters eines Kabelsystems, insbesondere eines Hoch- oder Höchstspannungskabelsystems eines Energieversorgungssystems.

Mantelspannungsableiter werden als Überspannungsableiter in Energieversorgungssystemen eingesetzt, um transiente Überspannungen, wie beispielsweise Schaltüberspannungen und Blitzüberspannungen, zu begrenzen und ein Versagen der Isolation des jeweiligen Betriebsmittels zu verhindern. Dabei werden herkömmlicherweise Mantelspannungsableiter bei Kabelsystemen an Muffen installiert und befinden sich typischerweise zwischen dem Mantel desjenigen Kabels, das mit der Muffe verbunden ist, und der Erdung oder zwischen zwei Mänteln zweier Kabelphasen, wenn es sich um ein Kabelsystem mit so genannten Auskreuzmuffen oder Cross-Bonding-Muffen handelt. Bei mehrphasigen Kabelsystemen besteht die Aufgabe der einzelnen Mantelspannungsableiter darin, die Mantelschirme der einzelnen Phasen auszukreuzen, um indizierte Mantelstromverluste zu reduzieren und im Fehlerfall Potentialdifferenzen zwischen den einzelnen Kabelmänteln zu begrenzen oder transiente Überspannungen in die Erde abzuleiten.

Um einen ordnungsgemäßen Betrieb derartiger Mantelspannungsableiter zu gewährleisten, ist ein zuverlässiges Ableitermonitoring unerlässlich, um den aktuellen Zustand des jeweiligen Mantelspannungsableiters überwachen zu können. Wie bereits erläutert worden ist, besteht die wesentliche Funktion eines Mantelspannungsableiters darin, transiente Überspannungen abzuführen, indem der Mantelspannungsableiter aufgrund seiner nicht linearen Widerstandscharakteristik aus einem hochohmigen Betriebszustand kurzzeitig in einen gut leitenden Zustand übergeht. Die Energie des dabei auftretenden Ableitstromes wandelt der Mantelspannungsableiter in Wärme um. Übersteigt die Energie im Ableiter die maximal abführbare Energie, kann neben dem eigentlichen Betriebszustand und dem leitfähigen Zustand ein weiterer Zustand auftreten, in dem der Ableiter zerstört ist und keine Verbindung zwischen dem Kabelmantel und dem Erdpotential besteht.
Das Dokument DE 196 29 481 A1 zeigt eine Vorrichtung zur Überwachung eines Mantelspannungsableiters eines Kabelsystems, die eine Prüfsignalquelle zum Erzeugen eines Prüfsignals und einen Sensor umfasst. Das Prüfsignal wird in eine Messschleife eingespeist, die den Mantelspannungsableiter einschließt. Mit einem Sensor wird an der Messschleife ein Messsignal abgegriffen, welches von einer frequenzabhängigen Impedanz des Mantelspannungsableiters abhängig ist, und durch dessen Auswertung wird auf einen Zustand des Mantelspannungsableiters geschlossen.

Der vorliegenden Erfindung liegt die Aufgabe zugrunde, ein Verfahren und eine Vorrichtung zur Überwachung eines Mantelspannungsableiters eines Kabelsystems bereitzustellen, womit auf einfache Art und Weise zuverlässig der Zustand des Mantelspannungsableiters überwacht werden kann.

Diese Aufgabe wird erfindungsgemäß durch eine Vorrichtung zur Überwachung eines Mantelspannungsableiters eines Kabelsystems mit den Merkmalen des Patentanspruches 1 bzw. ein Verfahren mit den Merkmalen des Patentanspruches 14 gelöst. Die abhängigen Patentansprüche definieren bevorzugte und/oder vorteilhafte Ausführungsformen der vorliegenden Erfindung.

Erfindungsgemäß wird zur Überwachung eines Mantelspannungsableiters eines Kabelsystems ein Prüfsignal in eine Messschleife, welche den Mantelspannungsableiter beinhaltet, eingespeist, um durch Auswertung eines an der Messschleife abgegriffenen Messsignals, welches von der frequenzabhängigen Impedanz des Mantelspannungsableiters abhängig ist, auf den Zustand des Mantelspannungsableiters schließen zu können.

Vorzugsweise wird dabei das Frequenzspektrum des Messsignals ausgewertet, wobei gemäß einer bevorzugten Ausführungsform die Ableiterimpedanz und die Kabelimpedanz zu einem Schwingkreis verschaltet sind, so dass der Mantelzustand beispielsweise aus der Lage oder Amplitude der Resonanzfrequenz dieses Schwingkreises abgeleitet werden kann.

Als Prüfsignal kann ein Kalibrierimpuls, vorzugsweise ein Niederspannungsimpuls, in die Messschleife eingeprägt werden. Ebenso ist es möglich, ein sich hinsichtlich seiner Kurvenform, Amplitude und/oder Frequenz über die Zeit variierendes Prüfsignal zuzuführen, wobei es sich bei dem Prüfsignal auch um ein Rauschsignal oder ein Wobble-Signal handeln kann. Die Einspeisung des Prüfsignals kann vorzugsweise in das Schirmsystem einer Kabelmuffe des zu überwachenden Kabelsystems erfolgen.

Gemäß einer bevorzugten Ausführungsform kann das Einspeisen bzw. Einkoppeln des Prüfsignals und das Erfassen bzw. Auskoppeln des Messsignals vorzugsweise galvanisch entkoppelt erfolgen, wobei hierzu beispielsweise induktive Sensoren eingesetzt werden können.

Die vorliegende Erfindung ermöglicht eine zuverlässige kontinuierliche Überwachung von Mantelspannungsableitern während des Betriebs des jeweiligen Kabelsystems, wobei die Überwachung automatisch rechnergestützt erfolgen kann, ohne dass nach der einmaligen Installation eine Bedienung am jeweiligen Mantelspannungsableiter notwendig ist. Die Auswertung des Messsignals bzw. der entsprechenden Messdaten kann in einer Recheneinheit erfolgen, die sich nicht direkt am Mantelspannungsableiter bzw. am Kabelsystem befinden muss.

Die Erfindung eignet sich bevorzugt zur Überwachung des Zustands von Mantelspannungsableitern eines Hoch-/Höchstspannungskabelsystems, welches Bestandteil eines Energieversorgungssystems ist, ohne jedoch darauf beschränkt zu sein.

Die Erfindung wird nachfolgend näher unter Bezugnahme auf die beigefügte Zeichnung anhand bevorzugter Ausführungsbeispiele erläutert.
Fig. 1 zeigt ein dreiphasiges Kabelsystem mit einer Vorrichtung zur Überwachung des Zustands von Mantelspannungsableitern dieses dreiphasigen Kabelsystems gemäß einer ersten Ausführungsform der vorliegenden Erfindung, und
Fig. 2 zeigt ein dreiphasiges Kabelsystem mit einer Vorrichtung zur Überwachung des Zustands von Mantelspannungsableitern dieses dreiphasigen Kabelsystems gemäß einem zweiten Ausführungsbeispiel der vorliegenden Erfindung.

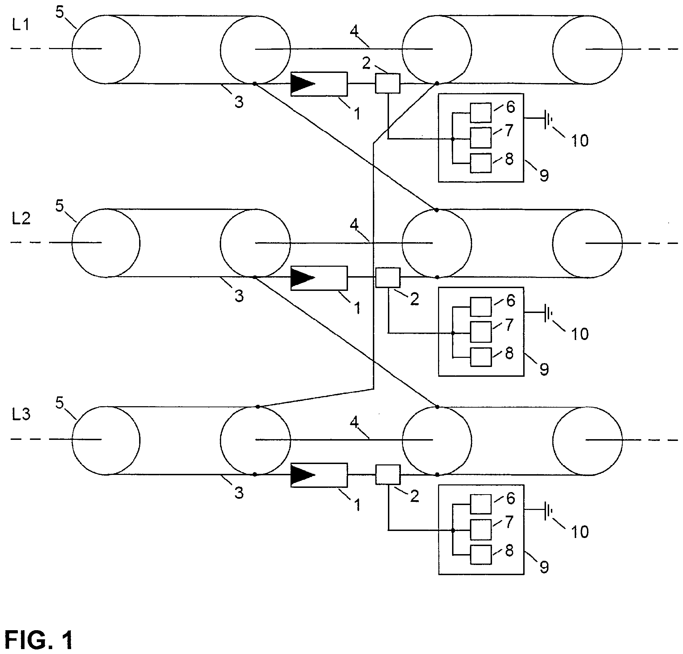

Fig. 1 zeigt einen Abschnitt eines dreiphasigen Kabelsystems, wobei insbesondere eine Verbindungsstelle von Energiekabelteilstrecken 5 des dreiphasigen Kabelsystems dargestellt ist. Jeder Phase L1, L2 und L3 ist ein Energiekabel mit einem Innenleiter 4 und einem Kabelmantel 3 zugeordnet, wobei die Kabelmäntel 3 der Energiekabel der jeweiligen Phasen L1, L2 und L3 miteinander galvanisch verbunden sind.

Zwischen den Kabelmänteln 3 zweier Energiekabelteilstrecken einer Phase ist jeweils ein Mantelspannungsableiter 1 vorgesehen, welcher zum Abführen von transienten Überspannungen dient, indem der Mantelspannungsableiter 1 aufgrund seiner nicht linearen Widerstandscharakteristik aus seinem hochohmigen Betriebszustand, in dem der Mantelspannungsableiter eine konstante Kapazität besitzt, kurzzeitig in einen gut leitenden Zustand übergeht. Die Energie des Ableitstroms wandelt der Mantelspannungsableiter in Wärme um. Übersteigt die Energie im Mantelspannungsableiter die maximal abführbare Energie, kann der Mantelspannungsableiter zerstört werden, so dass keine Verbindung zwischen dem jeweiligen Kabelmantel 3 und dem Erdpotential besteht.

Um den Zustand der einzelnen Mantelspannungsableiter 1 in Fig. 1 kontinuierlich während des Betriebs des dreiphasigen Kabelsystems überwachen zu können, ist gemäß Fig. 1 für jeden Mantelspannungsableiter 1 ein Mess- und Überwachungssystem 9 vorgesehen, wobei jedoch auch die Funktionen der einzelnen Mess- und Überwachungssysteme 9 in einer gemeinsamen Mess- und Überwachungseinheit realisiert sein können. Jedes Mess- und Überwachungssystem 9 ist gemäß Fig. 1 geerdet (vgl. Bezugszeichen 10) und verfügt über eine Prüfsignalquelle 6 zur Erzeugung eines Prüfsignals, eine Messeinrichtung 7 zur Erfassung und Auswertung eines an dem jeweiligen Mantelspannungsableiter 1 abgegriffenen Messsignals und eine Teilentladungsmesseinrichtung 8 zur zusätzlichen Durchführung einer Teilentladungsmessung.

Das von der Prüfsignalquelle 6 erzeugte Prüfsignal wird in einen Messkreis oder eine Messschleife, welche den jeweils zu überwachenden Mantelspannungsableiter 1 beinhaltet, eingespeist, wobei die Messeinrichtung 7 ein an der jeweiligen Messschleife abgegriffenes Messsignal, welches sich abhängig von der frequenzabhängigen Impedanz des jeweils zu überwachenden Mantelspannungsableiters verändert, erfasst, um durch Auswertung dieses Messsignals auf den jeweils aktuellen Zustand des Mantelspannungsableiters 1 zu schließen. Zur Überwachung des jeweiligen Mantelspannungsableiters wird vorzugsweise das Frequenzspektrum des in den jeweiligen Ableiterzweig eingeprägten Prüfsignals analysiert, welches sich abhängig von dem Zustand des jeweiligen Mantelspannungsableiters verändert (Zustand 1: der Ableiter befindet sich im Betrieb und ist voll funktionsfähig und besitzt eine konstante Kapazität; Zustand 2: der Ableiter ist in den leitfähigen Zustand übergegangen, und ein leitfähiger Kanal ist im Ableiter entstanden; Zustand 3: der Ableiter ist zerstört, und es besteht keine Verbindung zwischen dem Kabelmantel 3 und dem Erdpotential 10). Durch Auswertung der frequenzabhängigen Impedanz der jeweiligen Messschleife, welche sich in Abhängigkeit vom Zustand des Mantelspannungsableiters 1 verändert, kann zuverlässig auf den Zustand des Mantelspannungsableiters 1 geschlossen werden.

Als Prüfsignal können von der jeweiligen Prüfsignalquelle 6 Kalibrierimpulse, vorzugsweise Niederspannungspulse oder dergleichen, erzeugt werden, die in das Schirmssystem einer Kabelmuffe, an welcher der jeweilige Mantelspannungsableiter 1 angebracht ist, eingespeist werden. Allgemein kann es sich jedoch bei dem Prüfsignal auch um ein Signal handeln, welches sich hinsichtlich seiner Kurvenform, Amplitude und/oder Wiederholrate bzw. Frequenz verändert, wobei es sich insbesondere auch um ein Wobble-Signal handeln kann, d.h. ein Signal mit einer sich periodisch von einem Startwert zu einem Endwert hin veränderten Frequenz. Ebenso kann es sich bei dem Prüfsignal um ein Rauschsignal handeln, wobei vorzugsweise ein Signal mit einem bandbegrenzten weißen Rauschen eingesetzt werden kann.

Gemäß Fig. 1 erfolgt die Einkopplung des Prüfsignals in die jeweilige Messschleife über eine Einrichtung 2, welche mehrere Aufgaben erfüllt. Zum einen wird mit der Einrichtung 2, welche in Form eines Sensors ausgestaltet ist, das Prüfsignal in die jeweilige Messschleife eingespeist. Zum anderen dient die Einrichtung 2 zum Auskoppeln des Messsignals, d.h. der Prüfsignalantwort, um das Messsignal der jeweiligen Messeinrichtung 7 zuzuführen. Schließlich dient die Einrichtung 2 bei der in Fig. 1 dargestellten Ausführungsform auch zur Teilentladungsmessung in Kombination mit der im Überwachungs- und Messsystem 9 enthaltenen Teilentladungsmesseinrichtung 8, da das Messsignal neben dem eigentlichen Prüfsignal auch Teilentladungspulse, die möglicherweise in der Isolation des Kabelsystems entstehen, enthalten kann.

Die Einkopplung des Prüfsignals in die jeweilige Messschleife sowie die Auskopplung des an der jeweiligen Messschleife abgegriffenen Messsignals erfordert gemäß einer bevorzugten Ausführungsform keine galvanische Verbindung zu dem jeweiligen Mantelspannungsableiter 1, so dass die Prüfsignaleinspeisung und die Messsignalauskopplung jeweils von dem Mantelspannungsableiter 1 entkoppelt erfolgen kann. Zu diesem Zweck kann beispielsweise ein induktiver Sensor 2 (z.B. ein "High Frequency Current Transformer"-Sensor) verwendet werden. Ein derartiger induktiver Sensor 2 kann aus lediglich einem Teil oder aus mehreren Teilen bestehen und in der Mitte des Sensors eine Öffnung aufweisen, in die die jeweils zu vermessende Ableiterzuleitung gelegt ist. Der induktive Sensor besitzt einen Masseanschluss und ist durch eine Isolation von der jeweiligen Ableiterzuleitung getrennt. Induktive Sensoren mit zwei Teilen sind als sogenannte "Split Core HFCTs" bekannt und ermöglichen eine Montage ohne die vorherige Öffnung von Mantelspannungsableiterverbindungen.

Allgemein ist der zur Prüfsignaleinkopplung und Messsignalauskopplung vorgesehene Sensor 2 vorzugsweise in der Nähe des jeweils zu überwachenden Mantelspannungsableiters 1 angeordnet, wobei sich der Sensor 2 beispielsweise sowohl oberhalb des Mantelspannungsableiters 1 als auch unterhalb des Mantelspannungsableiters 2 befinden kann. Für die zusätzliche Durchführung einer Teilentladungsmessung kann es vorteilhaft sein, wenn sich der Sensor 2 oberhalb des Mantelspannungsableiters 1 befindet, um nicht die Empfindlichkeit der Teilentladungsmessung zu beeinträchtigen.

Das über den jeweiligen Sensor 2 ausgekoppelte Messsignal wird der in dem jeweiligen Mess- und Überwachungssystem 9 enthaltenen Messeinrichtung 7 zugeführt wobei die Messeinrichtung 7 vorzugsweise derart ausgestaltet ist, dass sie das Frequenzspektrum des Messsignals, welches sich abhängig von der frequenzabhängigen Impedanz des Mantelspannungsableiters 1 verändert, auswertet, um auf den Zustand des Mantelspannungsableiters 1 zu schließen. Die in Fig. 1 gezeigten Komponenten sind dabei vorzugsweise derart verschaltet, dass die Impedanz des Mantelspannungsableiters 1, die Impedanz des jeweiligen Energiekabels 5 und die Impedanz des jeweiligen Sensors 2 einen Schwingkreis bilden, so dass durch Auswertung einer Veränderung der Amplitude und/oder Lage der Resonanzfrequenz dieses Schwingkreises auf den Zustand des Mantelspannungsableiters 1 geschlossen werden kann. Jedem Zustand des Mantelspannungsableiters 1 kann eine spezifische Amplitude und Lage der Resonanzfrequenz zugeordnet sein, so dass bei Feststellen einer Veränderung der Amplitude oder Lage der Resonanzfrequenz auf einfache Art und Weise auf den Zustand des Mantelspannungsableiters 1 geschlossen werden kann. Zu diesem Zweck kann die aktuelle Messkurve des Messsignals mit einem zuvor aufgezeichneten und abgespeicherten Frequenzspektrums eines funktionsfähigen Mantelspannungsableiters verglichen werden.

Die zuvor beschriebene Messung, welche vorzugsweise im Frequenzbereich erfolgt, kann unter Umständen in einer von Störsignalen überlagerten Umgebung stattfinden, wodurch die Auswertung des von derartigen Störsignalen überlagerten Messsignals erschwert wird. Durch verschiedene Signalverarbeitungsverfahren (beispielsweise Korrelationsverfahren) kann das eigentliche Prüfsignal bzw. die Prüfsignalantwort in dem mit den Störsignalen überlagerten Messsignal wiederaufgefunden werden, um somit die Genauigkeit bei der Überwachung des Zustands des jeweiligen Mantelspannungsableiters 1 zu erhöhen.

Das zuvor anhand von Fig. 1 beschriebene Überwachungsverfahren kann sowohl bei im Betrieb befindlichen Kabelsystemen als auch bei vom Energieversorgungsnetz getrennten Kabelsystemen angewendet werden. Vorzugsweise wird das Überwachungsverfahren im Betrieb, d.h. online, bei einem unter Spannung stehenden Kabelsystem durchgeführt, wobei nach der einmaligen Installation der zuvor erläuterten Überwachungs- und Messsysteme 9 keine Bedienung des Überwachungsverfahrens an den einzelnen Mantelspannungsableitern 1 mehr erforderlich ist. Das Überwachen der Mantelspannungsableiter 1 findet vorzugsweise rechner- bzw. computergestützt statt, wobei die Auswertung der Messdaten in einer Recheneinheit erfolgt, welche sich vorzugsweise nicht direkt an den einzelnen Mantelspannungsableitern 1 oder in der Nähe des zu überwachenden Kabelsystems befindet. Zu diesem Zweck können die in Fig. 1 dargestellten Mess- und Überwachungssysteme 9 in einer Recheneinheit integriert sein, welche über ein Busssystem mit den einzelnen Sensoren 2 verbunden ist.

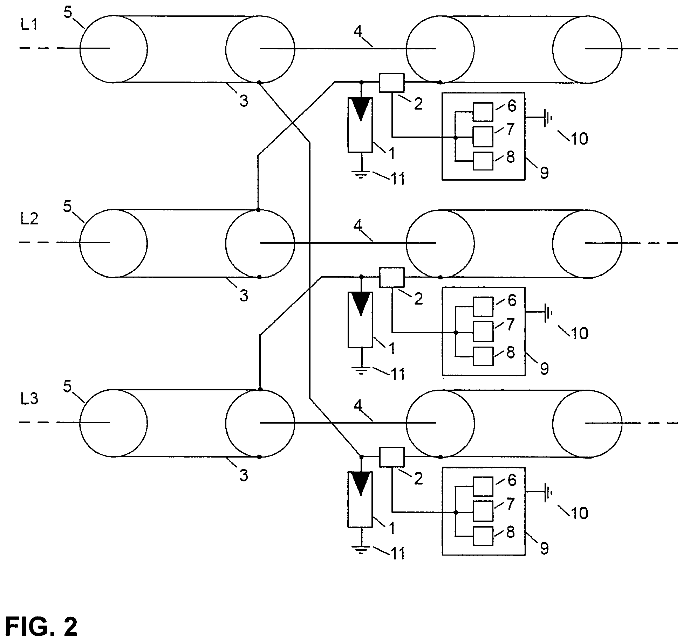

Fig. 2 zeigt ein zweites Ausführungsbeispiel der vorliegenden Erfindung, wobei in Fig. 2 diejenigen Komponenten, welche den in Fig. 1 gezeigten Komponenten entsprechen, mit denselben Bezugszeichen versehen sind.

Das in Fig. 2 gezeigte Ausführungsbeispiel unterscheidet sich von dem in Fig. 1 gezeigten Ausführungsbeispiel lediglich dadurch, dass die einzelnen Mantelspannungsableiter 1 gegen Erde geschaltet sind und demzufolge jeweils über eine Erdung 11 verfügen. Jeder Sensor 2 befindet sich oberhalb des jeweils zu überwachenden Mantelspannungsableiters 1 und ist ähnlich zu Fig. 1 mit dem jeweiligen Mess- und Überwachungssystem 9 verbunden. Ansonsten entspricht die Funktionsweise des in Fig. 2 dargestellten Ausführungsbeispiels dem in Fig. 1 dargestellten Ausführungsbeispiel, so dass auf die obigen Erläuterungen zur Fig. 1 verwiesen werden kann.

## Patentansprüche

1. Vorrichtung zur Überwachung eines Mantelspannungsableiters (1) eines Kabelsystems (L1-L3, 3-5),
mit einer Prüfsignalquelle (6) zum Erzeugen eines in eine Messschleife, welche den Mantelspannungsableiter (1) umfasst, einzuspeisenden Prüfsignals, und
mit einer Messeinrichtung (7) zum Erfassen eines an der Messschleife abgegriffenen Messsignals, welches von einer frequenzabhängigen Impedanz des Mantelspannungsableiters (1) abhängig ist, um durch Auswertung des Messsignals auf einen Zustand des Mantelspannungsableiters (1) zu schließen,
**dadurch gekennzeichnet,**
**dass** die Vorrichtung ferner aufweist:
eine Teilentladungsmesseinrichtung (8) zur Erfassung von an dem Kabelsystem (L1-L3, 3-5) auftretenden Teilentladungspulsen anhand des Messsignals, und
einen Sensor (2) zum Abgreifen des Messsignals an der Messschleife, wobei der Sensor (2) dazu ausgestaltet ist, zwischen einen Kabelmantel (3) des Kabelsystems (L1-L3, 3-5) und den Mantelspannungsableiter (1) geschaltet zu werden und derart ausgestaltet ist, dass
das Prüfsignal der Prüfsignalquelle (6) mittels des Sensors (2) in die Messschleife eingespeist werden kann.

2. Vorrichtung nach Anspruch 1,
**dadurch gekennzeichnet,**
**dass** die Prüfsignalquelle (6) ein Pulssignal, ein Rauschsignal oder ein sich hinsichtlich seiner Kurvenform, Amplitude und/oder Frequenz periodisch veränderndes Signal als das Prüfsignal erzeugt.

3. Vorrichtung nach Anspruch 1 oder Anspruch 2,
**dadurch gekennzeichnet,**
**dass** die Prüfsignalquelle (6) derart mit dem Kabelsystem (L1-L3, 3-5) koppelbar ist, dass das Prüfsignal in ein Schirmsystem einer Kabelmuffe, an welcher der Mantelspannungsableiter (1) angebracht ist, eingespeist wird.

4. Vorrichtung nach einem der vorhergehenden Ansprüche, **dadurch gekennzeichnet, dass** die Prüfsignalquelle (6) und die Messeinrichtung (7) in einer in Form einer integralen Einheit ausgestalteten Einrichtung (9) enthalten sind.

5. Vorrichtung nach Anspruch 4, **dadurch gekennzeichnet, dass** die Einrichtung (9) zudem die Teilentladungsmesseinrichtung (8) aufweist.

6. Vorrichtung nach einem der vorhergehenden Ansprüche, **dadurch gekennzeichnet, dass** der Sensor (2) um eine mit dem Mantelspannungsableiter (1) verbundene Leitung herum anbringbar ist.

7. Vorrichtung nach einem der vorhergehenden Ansprüche, **dadurch gekennzeichnet, dass** das Prüfsignal der Prüfsignalquelle (6) von dem Mantelspannungsableiter (1) galvanisch entkoppelt in die Messschleife eingespeist und das Messsignal galvanisch entkoppelt an der Messschleife abgegriffen werden kann.

8. Vorrichtung nach Anspruch 7, **dadurch gekennzeichnet, dass** über eine induktive Kopplung das Prüfsignal in die Messschleife eingespeist und das Messsignal an der Messschleife abgegriffen werden kann.

9. Vorrichtung nach einem der vorgehenden Ansprüche, **dadurch gekennzeichnet, dass** die Messeinrichtung (7) zur Auswertung des Frequenzspektrums des Messsignals ausgestaltet ist, um durch Auswertung des Frequenzspektrums des Messsignals auf den Zustand des Mantelspannungsableiters (1) zu schließen.

10. Vorrichtung nach Anspruch 9, **dadurch gekennzeichnet, dass** der Mantelspannungsableiter (1) derart mit dem Kabelsystem (L1-L3, 3-5) und der Messeinrichtung (7) verschaltbar ist, dass die Impedanz des Mantelspannungsableiters (1) und eine Impedanz des Kabelsystems (L1-L3, 3-5) Bestandteile eines Schwingkreises sind, und
dass die Messeinrichtung (7) derart ausgestaltet ist, dass sie zur Erkennung des Zustands des Mantelspannungsableiters (1) eine Lage oder Amplitude einer Resonanzfrequenz des Schwingkreises auswertet.

11. Vorrichtung nach einem der vorhergehenden Ansprüche, **dadurch gekennzeichnet, dass** die Messeinrichtung (7) Bestandteil einer von dem Kabelsystem (L1-L3, 3-5) und dem Mantelspannungsableiter (1) örtlich entfernten Recheneinheit (9) ist, wobei die Recheneinheit (9) über eine Leitung zur Übertragung des Messsignals mit der Messschleife verbunden ist.

12. Vorrichtung nach einem der vorhergehenden Ansprüche, **dadurch gekennzeichnet, dass** die Vorrichtung zur Überwachung des Mantelspannungsableiters (1) während eines Betriebs des Kabelsystems (L1-L3, 3-5) ausgestaltet ist.

13. Energieversorgungssystem mit einem Hochspannungskabelsystem (L1-L3, 3-5) und einer Vorrichtung nach einem der vorhergehenden Ansprüche zur Überwachung mindestens eines Mantelspannungsableiters (1) des Hochspannungskabelsystems (L1-L3, 3-5).

14. Verfahren zur Überwachung eines Mantelspannungsableiters (1) eines Kabelsystems (L1-L3, 3-5),
umfassend die Schritte
Einspeisen eines Prüfsignals in eine Messschleife, welche den Mantelspannungsableiter (1) umfasst, und
Erfassen mit Hilfe eines Sensors (2) eines an der Messschleife abgegriffenen Messsignals, welches von einer frequenzabhängigen Impedanz des Mantelspannungsableiters (1) abhängig ist, um durch Auswertung des Messsignals auf einen Zustand des Mantelspannungsableiters (1) zu schließen,
**gekennzeichnet durch**
Erfassen, mittels einer Teilentladungsmesseinrichtung (8), von an dem Kabelsystem (L1-L3, 3-5) auftretenden Teilentladungspulsen anhand des Messsignals, wobei der Sensor (2) zwischen einen Kabelmantel (3) des Kabelsystems (L1-L3, 3-5) und den Mantelspannungsableiter (1) geschaltet ist und
wobei das Prüfsignal mit Hilfe des Sensors (2) in die Messschleife eingespeist wird.

15. Verfahren nach Anspruch 14, **dadurch gekennzeichnet, dass** das Verfahren automatisch rechnergestützt durchgeführt wird.

16. Verfahren nach Anspruch 14 oder Anspruch 15, **dadurch gekennzeichnet, dass** das Verfahren unter Verwendung einer Vorrichtung nach einem der Ansprüche 1-12 durchgeführt wird.

## Claims

1. Apparatus for monitoring a sheath voltage arrester (1) of a cable system (L1-L3, 3-5), comprising
a test signal source (6) for producing a test signal which is to be supplied to a measuring loop which comprises the sheath voltage arrester (1), and
a measuring device (7) for detecting a measurement signal which is measured at the measuring loop and which is dependent on a frequency-dependent impedance of the sheath voltage arrester (1) in order to establish a status of the sheath voltage arrester (1) by evaluating the measurement signal,
**characterised in that**
the apparatus further comprises:
a partial discharge measuring device (8) for detecting partial discharge pulses occurring at the cable system (L1-L3, 3-5), and
a sensor (2) for detecting the measurement signal at the measuring loop, the sensor (2) being configured to be connected between a cable sheath (3) of the cable system (L1-L3, 3-5) and the sheath voltage arrester (1) and being configured such that the test signal of the test signal source (6) can be supplied to the measuring loop by means of the sensor (2).

2. Apparatus according to claim 1,
**characterised in that**
the test signal source (6) produces as the test signal a pulse signal, a noise signal, or a signal which changes periodically in terms of its curve shape, amplitude and/or frequency.

3. Apparatus according to claim 1 or claim 2,
**characterised in that**
the test signal source (6) can be coupled to the cable system (L1-L3, 3-5) in such a manner that the test signal is supplied to a shield system of a cable sleeve to which the sheath voltage arrester (1) is fitted.

4. Apparatus according to any one of the preceding claims,
**characterised in that**
the test signal source (6) and the measuring device (7) are contained in a device (9) which is constructed in the form of an integral unit.

5. Apparatus according to claim 4,
**characterised in that**
the device (9) additionally comprises the partial discharge measuring device (8).

6. Apparatus according to any one of the preceding claims,
**characterised in that**
the sensor (2) can be fitted around a line connected to the sheath voltage arrester (1).

7. Apparatus according to any one of the preceding claims,
**characterised in that**
the test signal of the test signal source (6) is supplied by the sheath voltage arrester (1) to the measuring loop in a galvanically decoupled manner and the measurement signal is measured at the measuring loop in a galvanically decoupled manner.

8. Apparatus according to claim 7,
**characterised in that**
by means of an inductive coupling, the test signal can be supplied to the measuring loop and the measuring signal can be measured at the measuring loop.

9. Apparatus according to any one of the preceding claims,
**characterised in that**
the measuring device (7) is configured for evaluating the frequency spectrum of the measurement signal in order to establish the status of the sheath voltage arrester (1) by evaluating the frequency spectrum of the measurement signal.

10. Apparatus according to claim 9,
**characterised in that**
the sheath voltage arrester (1) can be coupled with the cable system (L1-L3, 3-5) and the measuring device (7) in such a manner that the impedance of the sheath voltage arrester (1) and an impedance of the cable system are components of an oscillating circuit, and the measuring device (7) is configured in such a manner that, in order to establish the status of the sheath voltage arrester (1), it evaluates a position or amplitude of a resonance frequency of the oscillating circuit.

11. Apparatus according to any one of the preceding claims,
**characterised in that**
the measuring device (7) is a component of a processor unit (9) which is spatially remote from the cable system (L1-L3, 3-5) and the sheath voltage arrester (1), the processor unit (9) being connected to the measuring loop via a line in order to transfer the measurement signal.

12. Apparatus according to any one of the preceding claims,
**characterised in that**
the apparatus is configured for monitoring the sheath voltage arrester (1) during operation of the cable system (L1-L3, 3-5).

13. Energy supply system having a high-voltage cable system (L1-L3, 3-5) and an apparatus according to any one of the preceding claims for monitoring at least one sheath voltage arrester (1) of the high-voltage cable system (L1-L3, 3-5).

14. Method for monitoring a sheath voltage arrester (1) of a cable system (L1-L3, 3-5),
comprising the steps of
supplying a test signal to a measuring loop which comprises the sheath voltage arrester (1), and detecting by means of a sensor (2) a measurement signal which is measured at the measuring loop and which is dependent on a frequency-dependent impedance of the sheath voltage arrester (1) in order to establish a status of the sheath voltage arrester (1) by evaluating the measurement signal,
**characterised by**
detecting, by means of a partial discharge measuring device (8), partial discharge pulses occurring at the cable system (L1-L3, 3-5) using the measurement signal, wherein the sensor (2) is connected between a cable sheath (3) of the cable system (L1-L3, 3-5) and the sheath voltage arrester (1), and wherein the test signal is supplied to the measuring loop by means of the sensor (2).

15. Method according to claim 14,
**characterised in that**
the method is carried out automatically in a computer-assisted manner.

16. Method according to claim 14 or claim 15,
**characterised in that**
the method is carried out using an apparatus according to any one of claims 1-12.

## Revendications

1. Appareil de surveillance d'un protecteur de surtension de gaine (1) d'un système de câble (L1-L3, 3-5),
avec une source de signal d'essai (6) pour la génération d'un signal d'essai à alimenter dans une boucle de mesure, laquelle comprend le protecteur de surtension de gaine (1), et
avec un dispositif de mesure (7) pour la détection d'un signal de mesure prélevé au niveau de la boucle de mesure, lequel dépend d'une impédance, dépendant de la fréquence, du protecteur de surtension de gaine (1), pour conclure à un état du protecteur de surtension de gaine (1) par évaluation du signal de mesure,
**caractérisé en ce**
**que** l'appareil présente en outre :
un dispositif de mesure de décharge partielle (8) pour la détection d'impulsions de décharge partielle apparaissant au niveau du système de câble (L1-L3, 3-5) à l'aide du signal de mesure, et
un capteur (2) pour le prélèvement du signal de mesure au niveau de la boucle de mesure, dans lequel le capteur (2) est configuré pour être connecté entre une gaine de câble (3) du système de câble (L1-L3, 3-5) et le protecteur de surtension de gaine (1) et est configuré de sorte que le signal d'essai de la source de signal d'essai (6) peut être alimenté dans la boucle de mesure à l'aide du capteur (2).

2. Appareil selon la revendication 1,
**caractérisé en ce**
**que** la source de signal d'essai (6) génère un signal d'impulsion, un signal de bruit ou un signal à variation périodique en ce qui concerne sa forme de courbe, son amplitude et/ou sa fréquence en tant que signal d'essai.

3. Appareil selon la revendication 1 ou 2,
**caractérisé en ce**
**que** la source de signal d'essai (6) peut être couplée au système de câble (L1-L3, 3-5) de sorte que le signal d'essai est alimenté dans un système de blindage d'une boîte de jonction, au niveau de laquelle le protecteur de surtension de gaine (1) est monté.

4. Appareil selon l'une quelconque des revendications précédentes, **caractérisé en ce que** la source de signal d'essai (6) et le dispositif de mesure (7) sont contenus dans un dispositif (9) configuré sous la forme d'une unité intégrale.

5. Appareil selon la revendication 4, **caractérisé en ce que** le dispositif (9) présente en outre le dispositif de mesure de décharge partielle (8).

6. Appareil selon l'une quelconque des revendications précédentes, **caractérisé en ce que** le capteur (2) peut être monté autour d'un conducteur relié au protecteur de surtension de gaine (1).

7. Appareil selon l'une quelconque des revendications précédentes, **caractérisé en ce que** le signal d'essai de la source de signal d'essai (6) peut être alimenté dans la boucle de mesure découplé galvaniquement du protecteur de surtension de gaine (1) et le signal de mesure peut être prélevé au niveau de la boucle de mesure découplé galvaniquement.

8. Appareil selon la revendication 7, **caractérisé en ce que** le signal d'essai peut être alimenté dans la boucle de mesure par le biais d'un couplage inductif et le signal de mesure peut être prélevé au niveau de la boucle de mesure de même.

9. Appareil selon l'une quelconque des revendications précédentes, **caractérisé en ce que** le dispositif de mesure (7) est configuré pour l'évaluation du spectre de fréquence du signal de mesure pour conclure à l'état du protecteur de surtension de gaine (1) par évaluation du spectre de fréquence du signal de mesure.

10. Appareil selon la revendication 9, **caractérisé en ce que** le protecteur de surtension de gaine (1) peut être câblé avec le système de câble (L1-L3, 3-5) et le dispositif de mesure (7) de sorte que l'impédance du protecteur de surtension de gaine (1) et une impédance du système de câble (L1-L3, 3-5) font partie intégrante d'un circuit oscillant, et
**que** le dispositif de mesure (7) est configuré de sorte qu'il évalue une position ou amplitude d'une fréquence de résonance du circuit oscillant pour la détection de l'état du protecteur de surtension de gaine (1).

11. Appareil selon l'une quelconque des revendications précédentes, **caractérisé en ce que** le dispositif de mesure (7) fait partie intégrante d'une unité de calcul (9) distante localement du système de câble (L1-L3, 3-5) et du protecteur de surtension de gaine (1), dans lequel l'unité de calcul (9) est reliée à la boucle de mesure par le biais d'un conducteur pour la transmission du signal.

12. Appareil selon l'une quelconque des revendications précédentes, **caractérisé en ce que** l'appareil est configuré pour la surveillance du protecteur de surtension de gaine (1) pendant un fonctionnement du système de câble (L1-L3, 3-5).

13. Système d'alimentation en énergie avec un système de câble haute tension (L1-L3, 3-5) et un appareil selon l'une quelconque des revendications précédentes pour la surveillance d'au moins un protecteur de surtension de gaine (1) du système de câble haute tension (L1-L3, 3-5).

14. Procédé de surveillance d'un protecteur de surtension de gaine (1) d'un système de câble (L1-L3, 3-5),
comprenant les étapes consistant à
alimenter un signal d'essai dans une boucle de mesure, laquelle comprend le protecteur de surtension de gaine (1), et
détecter à l'aide d'un capteur (2) un signal de mesure prélevé au niveau de la boucle de mesure, lequel dépend d'une impédance, dépendant de la fréquence, du protecteur de surtension de gaine (1), pour conclure à un état du protecteur de surtension de gaine (1) par évaluation du signal de mesure,
**caractérisé par**
la détection, au moyen d'un dispositif de mesure de décharge partielle (8), d'impulsions de décharge partielle apparaissant au niveau du système de câble (L1-L3, 3-5) à l'aide du signal de mesure, dans lequel le capteur (2) est connecté entre une gaine de câble (3) du système de câble (L1-L3, 3-5) et le protecteur de surtension de gaine (1) et
dans lequel le signal d'essai est alimenté dans la boucle de mesure à l'aide du capteur (2).

15. Procédé selon la revendication 14, **caractérisé en ce que** le procédé est réalisé automatiquement supporté par ordinateur.

16. Procédé selon la revendication 14 ou 15, **caractérisé en ce que** le procédé est réalisé en utilisant un appareil selon l'une quelconque des revendications 1-12.
